# EUROPEAN PATENT APPLICATION

(11) **EP 1 096 548 A2**
(43) Date of publication of application: **02.05.2001**
(21) Application number: 00309089.1
(22) Date of filing: 16.10.2000
(51) Int. Cl.: H01L 21/00

(54) **Semiconductor wafer processing apparatus comprising a wafer presence detector and method**

(30) Priority: 29.10.1999 US 430768
(71) Applicant: LUCENT TECHNOLOGIES INC., Murray Hill, New Jersey 07974-0636 (US)
(72) Inventor: Bautista Villares, Jesus, Torrejon de Ardoz, Madrid (ES); Encinas Diaz, Jose Luis, Alcobendas, Madrid 28100 (ES); Quintana Romero, Jesus, Tres Cantos, Madrid 28760 (ES)
(74) Representative: Watts, Christopher Malcolm Kelway, Dr.

(57) **Abstract**

An apparatus for processing semiconductor wafers includes at least one wafer processing chamber, a wafer transfer module positioned adjacent the processing chamber, and a wafer cooling chamber having a window and a wafer support therein and being adjacent the wafer transfer module for receiving and cooling wafers downstream from the processing chamber. The apparatus also includes an optical sensor positioned adjacent the cooling chamber window and directed toward the wafer support for sensing wafer status. The sensor generates a signal responsive to sensed wafer status, and operation is interrupted if the wafer is missing or broken.

## Description

### Field Of The Invention

The present invention relates to the field of semiconductor fabrication and, more particularly, to a semiconductor wafer processing apparatus having a wafer presence detector.

### Background Of The Invention

Processing of semiconductor wafers is an essential step in the manufacture of integrated circuits, also known as ICs or simply, chips. A number of ICs may be manufactured on a semiconductor wafer, which is then cut into individual chips. Chip production involves many steps of semiconductor wafer processing, including several steps in which metals are deposited onto the wafers in vacuum deposition chambers.

Multiple chamber semiconductor wafer processing machines are in use in the industry for various processing steps in the fabrication of semiconductors. These machines may include several evacuable chambers, including processing chambers, transfer chambers, and loadlock chambers. The machines may perform several processes simultaneously on different wafers or sequentially on the same wafer. Such an apparatus as disclosed, for example, in U.S. Patent No. 5,882,165 to Maydan *et al*., generally includes a mechanical transfer arm positioned in a transfer chamber for moving a wafer sequentially through several processing modules. At times, however, the transfer arm may fail to pick up the wafer to be transferred, or the wafer breaks during the transfer. Unfortunately, such accidental events may go undetected until the processing cycle is completed and an operator unloads wafers from the machine. Failure to notice a missing or broken wafer potentially results in contamination of an entire lot of wafers as they continue to be processed through the apparatus.

### Summary Of The Invention

With the foregoing in mind, the present invention advantageously provides a semiconductor wafer processing apparatus which can detect wafer status in the cooling chamber.

This and other objects, features and advantages in accordance with the present invention are provided by an apparatus preferably comprising an optical sensor positioned adjacent the cooling chamber window and directed toward the wafer support for sensing wafer status. The apparatus also preferably includes a wafer processing chamber, a wafer transfer module positioned adjacent the processing chamber, a wafer cooling chamber having a window and a wafer support therein. The wafer cooling chamber is adjacent the wafer transfer module for receiving and cooling wafers downstream from the processing chamber. The optical sensor preferably includes an optical source and optical receiver.

An aspect of the invention includes a method for semiconductor processing in a semiconductor wafer processing apparatus comprising at least one wafer processing chamber, a wafer transfer module positioned adjacent the at least one processing chamber, and a wafer cooling chamber adjacent the wafer transfer module. The method preferably comprises the steps of processing a wafer in the processing chamber, transferring the wafer from the processing chamber to the cooling chamber using the transfer module, and providing and using a sensor associated with the wafer cooling chamber for sensing wafer status in the cooling chamber.

### Brief Description Of The Drawings

Some of the features, advantages, and benefits of the present invention having been stated, others will become apparent as the description proceeds when taken in conjunction with the accompanying drawings in which:
FIG. 1 is a schematic top plan view of the apparatus; and
FIG. 2 is a schematic cross sectional view of the cooling chamber as shown in FIG. 1; and
FIG. 3 is a flow chart illustrating the method according to an embodiment of the present invention.

### Detailed Description of the Preferred Embodiment

The present invention will now be described more fully hereinafter with reference to the accompanying drawings, in which preferred embodiments of the invention are shown. This invention may, however, be embodied in many different forms and should not be construed as limited to the illustrated embodiments set forth herein. Rather, these illustrated embodiments are provided so that this disclosure will be thorough and complete, and will fully convey the scope of the invention to those skilled in the art.

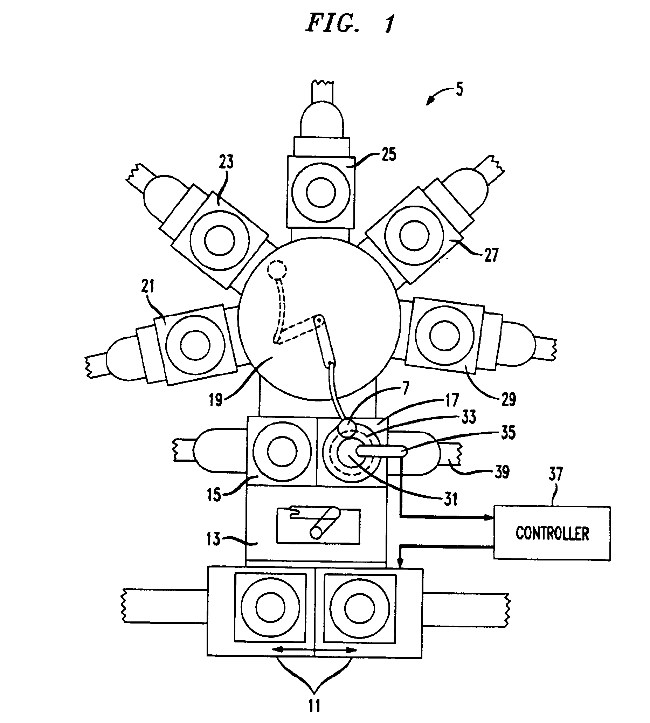

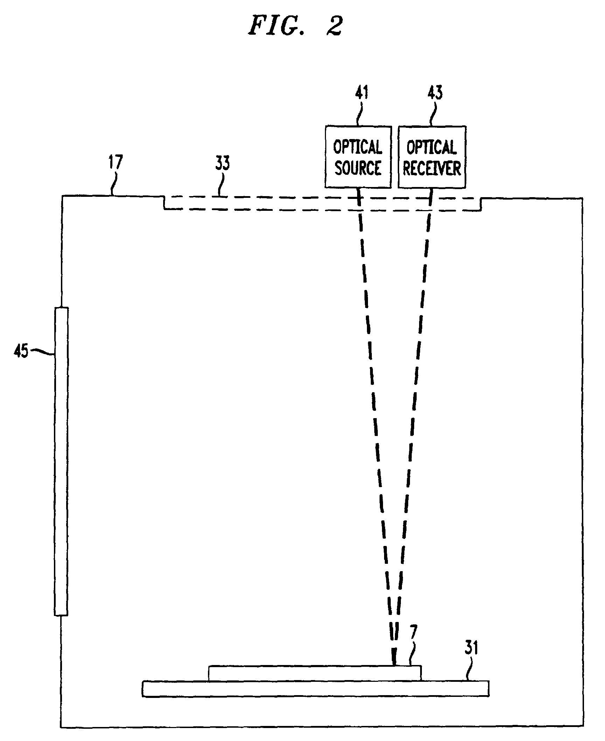

Referring to FIGS. 1 and 2, an apparatus **5** for processing a semiconductor wafer **7** is initially described. The apparatus **5** comprises at least one wafer processing chamber **21**, and five such chambers **21**, **23**, **25**, **27** and **29** in the illustrated embodiment The processing chambers may be for the deposition of materials, such as metals, as will be readily understood by those skilled in the art.

A wafer transfer module **19** is positioned adjacent the processing chambers for transferring wafers from one chamber to another. The further operation of the wafer transfer module **19** will also be readily understood by those skilled in the art and requires no further discussion herein.

A wafer cooling chamber **17** is positioned adjacent the wafer transfer module **19** for receiving and cooling wafers downstream from the processing chambers **29**. The wafer cooling chamber **17** comprises a wafer support **31** and a window **33** adjacent the wafer support and in spaced apart relation therefrom. In addition, an optical sensor **35** is positioned adjacent the window **33** on the outside thereof, and is directed toward the wafer support **31** for sensing wafer **7** status.

The sensor **35**, is preferably positioned to sense wafer **7** status through the window **33**, wherein the wafer status includes at least one of presence, absence and breakage of the wafer **7** within the cooling chamber **17**. The optical sensor **35** preferably generates a signal responsive to wafer status. In a preferred embodiment, the apparatus **5** includes a controller **37** for controlling operation of the apparatus **5**. Accordingly, the optical sensor **35** is connected to the controller **37** for interrupting operation responsive to the wafer status signal. The cooling chamber **17** preferably also includes a cooling gas inlet port **39** for admitting cooling gas to cool the wafer **7**.

In a preferred embodiment the apparatus further comprises at least one load lock chamber **11** downstream from the cooling chamber **17**. Loadlock chambers **11**, however, may function as both wafer inlet and wafer outlet chambers for the apparatus, as will be readily appreciated by those skilled in the art.

Chamber **13** is also a wafer transfer chamber associated with the loadlock chambers **11**. In the illustrated embodiment it is also noted that the processing chambers are arranged about a portion of an imaginary circle so that a wafer **7** may be transferred from one chamber to another sequentially by the transfer module **19** for processing, such as cleaning or metal deposition, and finally transferred for cooling in the cooling chamber **17**.

As shown schematically in FIG. 2, the optical sensor **35** preferably includes an optical source **41** and an optical receiver **43** cooperating therewith for sensing wafer **7** status. Those skilled in the art will understand that the optical sensor **35** may also include a plurality of optical sources and optical receivers cooperating to sense wafer status. Such a plurality of optical sources and optical receivers would be particularly useful in sensing a greater area of the wafer **7** to improve detection of breakage. In an alternate embodiment of the invention, the optical sensor **35** may also be positioned within the cooling chamber **17** itself. As also shown in FIG. 2, the cooling chamber **17** also further comprises an access port **45** for allowing operator access to the chamber. Skilled artisans will appreciate that such an access port may be positioned on the cooling chamber as practicable.

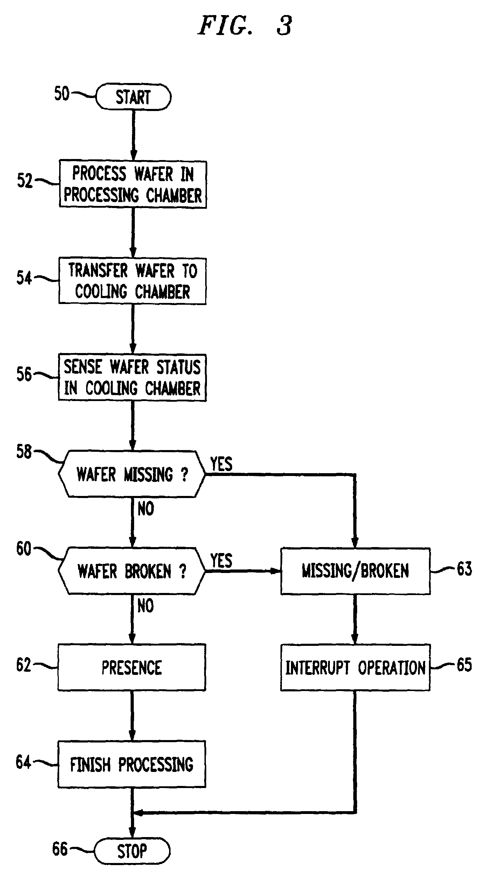

Another aspect of the invention, explained with reference to the flow chart of FIG. 3, is directed to a method for semiconductor processing in a semiconductor wafer processing apparatus comprising at least one wafer processing chamber, a wafer transfer module positioned adjacent the at least one processing chamber, and a wafer cooling chamber adjacent the wafer transfer module. The method starts (Block 50) by the step of processing a wafer in the processing chamber (Block 52), transferring the wafer from the processing chamber to the cooling chamber (Block 54) using the transfer module, and providing and using a sensor associated with the wafer cooling chamber for sensing wafer status in the cooling chamber (Block 56). In the method, wafer status monitored includes at least one of presence or absence of the wafer (Block 58), and breakage of the wafer (Block 60) within said cooling chamber. Responsive to the sensing step, the sensor generates a wafer status signal. If the sensing step indicates a missing wafer, or a broken wafer (Block 63), the appropriate trouble signal is generated, operation is interrupted (Block 65), and the method stops (Block 66). If the sensing step indicates a wafer is present and unbroken, the appropriate signal is generated (Block 62), and processing continues until finished (Block 64), whereupon the method stops (Block 66).

Many modifications and other embodiments of the invention will come to the mind of one skilled in the art having the benefit of the teachings presented in the foregoing descriptions and the associated drawings. Therefore, it is to be understood that the invention is not to be limited to the specific embodiments disclosed.

## Claims

1. A semiconductor wafer processing apparatus comprising:
at least one wafer processing chamber;
a wafer transfer module positioned adjacent said at least one processing chamber;
a wafer cooling chamber adjacent said wafer transfer module for receiving and cooling wafers downstream from said at least one processing chamber; and
a sensor associated with said wafer cooling chamber for sensing wafer status.

2. The apparatus of claim 1 wherein the wafer status includes at least one of presence, absence and breakage of the wafer within said cooling chamber.

3. The apparatus of claim 1 or claim 2 wherein said sensor comprises an optical source and an optical receiver cooperating therewith for sensing wafer status.

4. The apparatus of any of the preceding claims wherein said sensor generates a wafer status signal.

5. The apparatus of claim 4 further comprising a controller for controlling operation of the apparatus, and wherein said sensor is connected to said controller for interrupting operation responsive to the wafer status signal.

6. The apparatus of any of the preceding claims wherein said sensor is positioned within said cooling chamber.

7. The apparatus of any of claims 1 to 5 wherein said cooling chamber includes a window, and wherein said sensor is positioned outside said cooling chamber adjacent said window.

8. The apparatus of claim 3 wherein said optical source and said optical receiver are positioned outside said cooling chamber.

9. The apparatus of any of claims 1 to 5 wherein:
said wafer cooling chamber includes a wafer support and a window adjacent said wafer support; and
said sensor is an optical sensor positioned outside said window and directed toward said wafer support.

10. The apparatus of any of the preceding claims wherein said cooling chamber includes a cooling gas inlet port for admitting cooling gas to cool the wafer.

11. The apparatus of any of the preceding claims further comprising at least one load lock chamber downstream from said cooling chamber.

12. The apparatus of any of the preceding claims wherein said at least one processing chamber comprises at least one metal deposition chamber.

13. The apparatus of any of the preceding claims wherein said cooling chamber further comprises an access port for allowing operator access.

14. The apparatus of any of the preceding claims wherein:
there is a plurality of said wafer processing chambers having respective wafer receiving openings arranged about at least a portion of an imaginary circle; and
said wafer transfer module is positioned within the imaginary circle.

15. A method for semiconductor processing in a semiconductor wafer processing apparatus comprising at least one wafer processing chamber, a wafer transfer module positioned adjacent the at least one processing chamber, and a wafer cooling chamber adjacent the wafer transfer module, the method comprising the steps of:
processing a wafer in the at least one processing chamber;
transferring the wafer from the at least one processing chamber to the cooling chamber using the transfer module; and
providing and using a sensor associated with the wafer cooling chamber for sensing wafer status in the cooling chamber.

16. The method of claim 15 wherein the wafer status includes at least one of presence, absence and breakage of the wafer within said cooling chamber.

17. The method of claim 15 or claim 16 wherein the sensor generates a wafer status signal.

18. The method of claim 17 further comprising the step of interrupting operation of the apparatus responsive to the wafer status signal.

19. The method of any of claims 15 to 18 wherein the cooling chamber includes a window, and wherein the step of providing the sensor comprises positioning the sensor outside the cooling chamber adjacent the window.

20. The method of any of claims 15 to 19 wherein the step of providing the sensor comprises providing an optical sensor including an optical source and an optical receiver cooperating therewith for sensing wafer status.
